# EUROPÄISCHE PATENTSCHRIFT

(11) **EP 0 894 337 B1**
(45) Veröffentlichungstag und Bekanntmachung des Hinweises auf die Patenterteilung: **18.08.2004**
(21) Anmeldenummer: 97915451.5
(22) Anmeldetag: 27.03.1997
(51) Int. Cl.: H01L 21/00

(54) **ANLAGE ZUR NASSBEHANDLUNG VON SUBSTRATEN**
INSTALLATION FOR WET-TREATING SUBSTRATES
INSTALLATION POUR LE TRAITEMENT PAR VOIE HUMIDE DE SUBSTRATS

(30) Priorität: 17.04.1996 DE 19615108; 17.09.1996 DE 19637875
(43) Veröffentlichungstag der Anmeldung: 03.02.1999
(73) Patentinhaber: STEAG MicroTech GmbH, 72124 Pliezhausen (DE)
(72) Erfinder: WEBER, Martin, D-78073 Bad Dürrheim (DE); MEISTER, Dieter, D-78176 Blumberg (DE); WEHRLE, Felix, D-78166 Donaueschingen (DE); FUNKHÄNEL, Jürgen, D-78166 Donaueschingen (DE)
(74) Vertreter: Wagner, Karl H., Dipl.-Ing.
(86) Internationale Anmeldenummer: PCT/EP1997/001574
(87) Internationale Veröffentlichungsnummer: WO 1997/039475

(56) Entgegenhaltungen:
- EP-A- 0 385 536
- EP-A- 0 682 357
- DE-A- 4 413 077
- DE-A- 4 428 169
- US-A- 4 722 752
- US-A- 4 902 350
- PATENT ABSTRACTS OF JAPAN vol. 018, no. 599 (E-1631), 15.November 1994 -& JP 06 232244 A (KOMATSU ELECTRON METALS CO LTD), 19.August 1994,

## Beschreibung

Die vorliegende Erfindung bezieht sich auf eine Anlage bzw. ein Verfahren zur Naßbehandlung von Substraten in einem ein Behandlungsfluid enthaltenden Behälter, wobei die Substrate in einem Substratträger in den Behälter eingesetzt werden.

Aus EP-A-0 385 536 ist ein Verfahren zum Trocknen von Halbleiterwafern nach der Behandlung in einer Flüssigkeit bekannt. Ferner ist es aus dieser Druckschrift bekannt, in einer Kassette befindliche Wafer in einem Flüssigkeitsbad zu behandeln, wobei die Wafer während der Be-Handlung auf Auflagen in der Kassette aufliegen. Nach der Behandlung wird eine Hilfskassette direkt über die in der Flüssigkeit befindliche Kassette mit den Wafern bewegt. Eine messerartige Aushubvorrichtung hebt die Wafer aus der Flüssigkeit heraus, wobei die Wafer getrocknet werden. Während des Aushubs werden die Wafer in seitlichen Führungen der Kassette und - nach dem Austritt aus der Flüssigkeit - in seitlichen Führungen der Hilfskassette geführt. Wenn die Wafer vollständig aus der Flüssigkeit herausgehoben sind, wird die Kassette ebenfalls aus der Flüssigkeit herausgehoben und dabei getrocknet. Die Hilfskassette wird dabei nach oben bewegt, so daß die Wafer dann erneut außerhalb der Flüssigkeit auf den Auflagen der Kassette aufliegen.

Bei einer derartigen Anordnung tritt jedoch das Problem auf, daß die Wafer in der Kassette in dem Behälter nicht genügend ausgerichtet bzw. zentriert sind, so daß sie nicht ohne ein Risiko hinsichtlich Beschädigungen in externe Führungen, zum Beispiel in der oben erwähnten Hilfskassette oberhalb der Flüssigkeit herausgefahren werden können. selbst bei sehr geringen Abweichungen von der senkrechten Lage gelangen die Wafer nicht sicher in die externen Führungen hinein, so daß die Bruchgefahr groß ist. Die Transportkassetten sind starken Temperaturunterschieden ausgesetzt, - zum Beispiel treten bei Behandlungsprozessen Temperaturen von bis zu 170 °C auf -, so daß Toleranzmaße nicht eingehalten werden können bzw. sich die Kassette verzieht.

Aus der US-A-4 902 350 und der US-A-4 722 752 sind Verfahren und Vorrichtungen zum Reinigen, Spülen und Trocknen von Halbleiterwafern bekannt, bei denen die Wafer in einer Kassette in den Behandlungsbehälter eingebracht werden und eine gegenüber der Kassette bewegliche Vorrichtung die Substrate nach der Behandlung aus der Behandlungsflüssigkeit und aus der Kassette hebt.

Aus der DE-A-4 413 077 ist eine Vorrichtung und ein Verfahren zur chemischen Behandlung von Substraten bekannt. Die Vorrichtung weist eine Aufnahmevorrichtung für Substrate im Behälter eine messerartige Aushubvorrichtung und einen Substratträger auf.

Der Erfindung liegt die Aufgabe zugrunde, eine Anlage zur Naßbehandlung zu schaffen, mit der die Substrate im Behandlungsbehälter und beim Herausfahren aus dem Behandlungsbehälter möglichst genau ausrichtbar und zentrierbar sind.

Eine weitere der Erfindung zugrundeliegende Aufgabe ist es, die Position der Substrate im Behandlungsbehälter trotz auftretender Temperaturschwankungen während der Behandlung immer definiert zu halten. Auch dies soll das Ausrichten und Zentrieren der Substrate verbessern.

Die gestellte Aufgabe wird erfindungsgemäß mit einer Anlage gemäß Anspruch 1 sowie einem Verfahren gemäß Anspruch 42 gelöst.

Ein Vorteil der vorliegenden Erfindung besteht darin, daß insbesondere große Substrate, wie z.B. Halbleiter-Wafer mit einem Durchmesser von 300 mm, mit der erfindungsgemäßen Anlage getrocknet werden können.

Ein weiterer Vorteil der Erfindung besteht darin, daß durch eine gesonderte, behälterinterne Aufnahmevorrichtung für die Substrate die Kassetten, und insbesondere deren Aufnahmeschlitze für die Wafer derart konstruiert sein können, daß die Kassette beim Entfernen des Behandlungsfluids optimal getrocknet wird. Zur optimalen Ausrichtung der Substrate sind nämlich besonders enge Abschnitte in den Führungsschlitzen für die Substrate vorgesehen, die sich sehr schlecht trocknen lassen.

In einem bevorzugten Ausführungsbeispiel besteht der Vorteil darin, daß mittels eines vorgesehenen Adapters Substratträger verschiedener Größen in denselben Behälter einsetzbar sind und in einer definierten Position gehalten werden können.

Ein Substratträger weist dabei den Vorteil auf, daß sich auch bei einer Verformung des Substratträgers auf Grund von Temperaturänderungen die definierte Lage des Substratträgers nicht ändert.

Gemäß der vorliegenden Erfindung sind die Aufnahmevorrichtung für die Substrate und der Substratträger relativ zueinander bewegbar. Durch diese Relativbewegung wird die Übergabe der in dem Substratträger in den Behälter eingesetzten Substrate in die behälterinterne Aufnahmevorrichtung für die Substrate realisiert.

Die Relativbewegung der Aufnahmevorrichtung für die Substrate und des Substratträgers erfolgt in vertikaler Richtung. Dadurch kann das Trocknen der Substrate am effektivsten durchgeführt werden, da auf diese Weise das an den Substraten anhaftende Behandlungsfluid beim Austritt aus der Flüssigkeitsoberfläche am leichtesten entfernt werden kann. Ferner kann durch eine vertikale Relativbewegung der Aufnahmevorrichtung für die Substrate und des Substratträgers die Übergabe der Substrate von dem Substratträger an die Aufnahmevorrichtung für die Substrate oder die Übergabe der Substrate zurück in den Substratträger in einer kontinuierlichen Bewegung mit dem Herausheben und Trocknen der Substrate oder des Substratträgers vorgenommen.

Gemäß einem bevorzugten Ausführungsbeispiel der Erfindung weist die Anlage einen ersten Transportschlitten für die Substrat-Aufnahmevorrichtung und einen zweiten Transportschlitten für den Substratträger auf. Vorzugsweise weist der zweite Transportschlitten die Substratträger-Aufnahme auf. Die Substrate können in der Substrat-Aufnahmevorrichtung zentriert werden, und in einer kontinuierlichen Bewegung aus dem Behandlungsfluid des Behälters herausgefahren und getrocknet.

Vorzugsweise weist die Aufnahmevorrichtung Schlitze zur Zentrierung der Substrate auf. Vorteilhafterweise nimmt die Breite der Schlitze von der Schlitzöffnung zu dem Schlitzboden hin ab. Insbesondere ist eine Wand eines Schlitzes vertikal und eine zweite Wand des Schlitzes um einen ersten vorbestimmten Winkel zur Vertikalen geneigt. Durch diese besondere Schlitzform wird eine optimale Zentrierung der Substrate durch deren Klemmung in der Substrat-Aufnahmevorrichtung möglich. Eine derartige Ausbildung der Schlitze ist zwar hinsichtlich der Zentrierung der Substrate in der Aufnahmevorrichtung vorteilhaft, jedoch sollten die Substrate nicht während des Austritts aus dem Behandlungsfluid in derartigen Klemmschlitzen gehalten werden, da sich sonst Reste des Behandlungsfluids nicht von den Substraten bzw. der Aufnahmevorrichtung ablösen können.
Vorteilhafterweise schließen die Schlitzwände im Schlitzöffnungsbereich einen zweiten vorbestimmten Winkel mit der Vertikalen ein, wobei der zweite vorbestimmte Winkel größer als der erste vorbestimmte Winkel ist. Dadurch ergibt sich ein leichtes Einführen der Substrate in den Klemmschlitz.

Gemäß der Erfindung weist der Behälter eine messerartige Aushubvorrichtung für die Substrate auf, die insbesondere eine messerartige Leiste ist, und die durch einen Durchlaß in der Aufnahmevorrichtung, durch die Substratträgeröffnung und durch die Aufnahmeöffnung in der vertikalen Richtung bewegbar ist. Die messerartige Aushubvorrichtung kann auf diese Weise in einer kontinuierlichen Bewegung die Substrate zusammen mit der Aufnahmevorrichtung oder alleine, wenn die Substrate in externe Führungen. z.B. oberhalb des Behälters, eingreifen, unterstützen. Die messerartige Aushubvorrichtung hat den besonderen Vorteil, daß, wenn die Substrate gerade aus der Flüssigkeitsoberfläche austreten, die Tropfen an der messerartigen Leiste nach unten fließen.

Gemäß einem weiteren bevorzugten Ausführungsbeispiel der Erfindung weist die Anlage eine über dem Behälter aufsetzbare Haube auf. Vorteilhafterweise weist die Haube an wenigstens einer Innenwand Führungsschlitze für die Substrate auf. Die Schlitze in der Substrat-Aufnahmevorrichtung sind entsprechend den Führungsschlitzen der Haube ausgebildet. Die Haube erfüllt somit eine doppelte Funktion. Einerseits enthält die Haube eine Atmosphäre aus einem Dampf, so daß das Trocknen unter Ausnutzung des Marangoni-Effekts bewirkt werden kann (siehe dazu die eingangs genannnte EP-A-0 385 536) und andererseits sieht die Haube externe Führungen vor, so daß die Substrate oberhalb des Behälters lediglich durch die messerartige Aushubvorrichtung getragen und in den Führungsschlitzen der Haube geführt herausgehoben werden können. Die Substrat-Aufnahmevorrichtung dient in diesem Fall lediglich zum Halten und Zentrieren der Substrate in dem Behälter und muß daher nicht aus dem Behälter herausgefahren werden. Dadurch kann die oben im Detail beschriebene optimale Form für einen Klemmschlitz zum Zentrieren der Substrate in der Aufnahmevorrichtung eingesetzt werden.

Gemäß einem weiteren bevorzugten Ausführungsbeispiel der Erfindung werden zum Trocknen die Substrate vom Substratträger getrennt. Das getrennte Herausfahren der Substrate vom Substratträger verhindert, daß an den Kontaktstellen Reste des Behandlungsfluids bzw. Trocknungsflecken verbleiben.

Gemäß einem bevorzugten Ausführungsbeispiel sind Aufsetzstellen des Substratträgers mittig in den Seitenplatten ausgebildet. Aufsetzstellen können vorzugsweise auch mittig an den Längsstäben oder in von den Längsstäben schräg nach unten weisenden Stützen ausgebildet sein.

Vorteilhaft sind die Aufsetzstellen als Ausnehmungen, insbesondere als zentriernuten ausgebildet, in die im Behälter ausgebildete Vorsprünge, insbesondere Zentrierkeile eingreifen. Diese vorteilhafte Ausbildung ermöglicht eine sehr exakt definierte Positionierung des Substratträgers in dem Behandlungsbehälter.

Gemäß einem weiteren bevorzugten Ausführungsbeispiel kann der Substratträger wenigstens doppelwandig als Profilteile ausgebildete Seitenplatten aufweisen, die vorzugsweise mit Querstegen ausgebildet sein können. Die Querstege ermöglichen ein Handling, insbesondere ein Herausnehmen und Absetzen des Substratträgers, wobei dennoch eine insgesamt kompakte und handliche Form der Substratträger gewährleistet ist.
Gemäß einem bevorzugten Ausführungsbeispiel weist die erfindungsgemäße Anlage in den Behälter einsetzbare Adapter auf, die wenigstens zwei in Längs- und/oder Querrichtung mittig angeordnete Auflagestellen zum Auflegen eines Substratträgers auf-weisen. Dabei sind die Auflagestellen des Adapters vorzugsweise als Zentrierkeile entsprechend den am Substratträger ausgebildeten Zentriernuten ausgebildet.

Gemäß einem vorteilhaften Ausführungsbeispiel weist der Adapter zwei parallele zueinander beabstandete Längsbalken auf, die durch zwei senkrecht dazu angeordnete Querbalken verbunden sind.

Gemäß einem weiteren bevorzugten Ausführungsbeispiel weist der Adapter wenigstens zwei Fixierungslöcher auf, in die im Behälterboden der Anlage ausgebildete Fixierungsstifte eingreifen. Vorteilhaft ist jedoch auch eine Ausführungsform, bei der sowohl die Verbindung zwischen Adapter und Behälterboden und/oder die Verbindung zwischen Adapter und Substratträger in Form der zuvor beschriebenen Nuten und Zentrierkeile vorzugsweise mittig an den Längs- und/oder Querseiten ausgebildet ist.

Weitere bevorzugte Ausgestaltungen der Erfindung sind in den abhängigen Patentansprüchen angegeben.

Die Erfindung sowie weitere Einzelheiten und Vorteile derselben wird bzw. werden nachfolgend anhand eines Ausführungsbeispiels unter Bezugnahme auf die Figuren erläutert. Es zeigen:
- Fig. 1: eine Querschnittsansicht des Behälters eines Ausführungsbeispiels der erfindungsgemäßen Anlage zur Naßbehandlung;
- Fig. 2: eine Ansicht von oben auf den Behälter der Fig. 1;
- Fig. 3: eine Querschnittsansich eines Ausführungsbeispiels der erfindungsgemäßen Anlage zur Naßbehandlung;
- Fig. 4: eine Längsschnitttansicht einer Substrataufnahmevorrichtung;
- Fig. 5: eine Ansicht von oben auf die Substrataufnahmevorrichtung der Fig. 4;
- Fig. 6: eine Längsschnittansicht der Substrataufnahmevorrichtung der Fig. 4 und 5 mit einem damit verbundenen Haltemechanismus;
- Fig. 7: eine Ansicht von oben auf die Substrataufnahmevorrichtung mit dem damit verbundenen Mechanismus gemäß Fig. 6;
- Fig. 8: eine Querschnittsansicht der Substrataufnahmevorrichtung der Fig. 4 bis 7;
- Fig. 9: eine Schnittansicht eines Teils der Fig. 8 entlang der Linie C-C;
- Fig.10: eine Querschnittsansicht einer messerartigen Aushubvorrichtung für die Substrate mit einem damit verbundenen Haltemechanismus;
- Fig.11: eine Längsschnittansicht einer Aufnahme für den Substratträger mit einem damit verbundenen Haltemechanismus;
- Fig.12: eine Seitenansicht der Aufnahme für den Substratträger mit den damit verbundenen Haltemechanismus gemäß Fig. 11;
- Fig.13: eine Ansicht von oben auf die Aufnahme für den Substratträger mit den damit verbundenen Hubmechanismus der Fig. 11 und 12;
- Fig.14: eine perspektivische Ansicht eines Substratträgers;
- Fig.15: eine Querschnittsansicht des Substraträgers der Fig. 14;
- Fig.16: eine Ansicht von oben auf den Substratträger der Fig. 14 und 15;
- Fig.17: eine Längsschnittansicht des Substratträgers gemäß den Fig. 14 bis 16; und
- Fig.18: bis 23 einzelne Schritte zum Trocknen des Substrats mit einem Ausführungsbeispiel der erfindungsgemäßen Anlage;
- Fig.24: eine Aufsicht auf den Adapter;
- Fig.25: eine Längsschnittansicht des Adapters aus Fig. 24 entlang der in Fig. 24 eingezeichneten Schnittlinie A-A; und
- Fig.26: eine Querschnittansicht des Adapters aus den Fig. 24 und 25 entlang der in Figur 24 eingezeichneten Schnittlinie B-B.

In den Zeichnungen bezeichnen die gleichen Bezugszeichen die gleichen Elemente der Anlage zur Naßbehandlung von Substraten. Auf eine detaillierte Beschreibung von Elementen in einer Figur wird verzichtet, wenn diese Elemente im Zusammenhang mit anderen Figuren näher beschrieben werden.

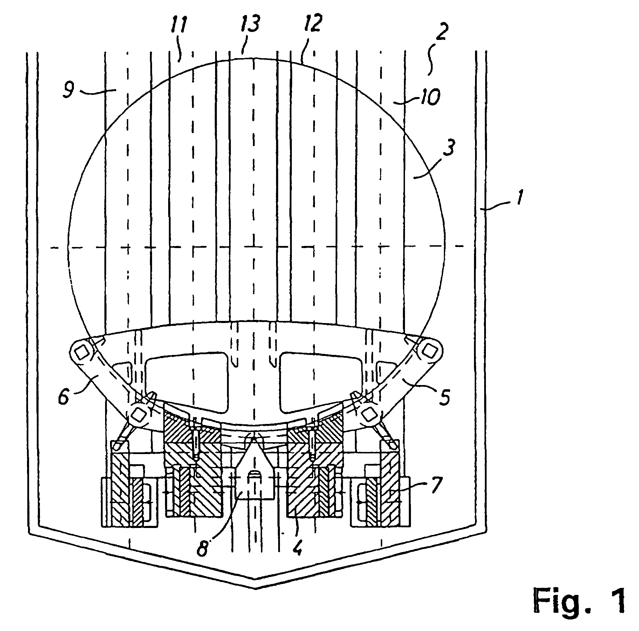

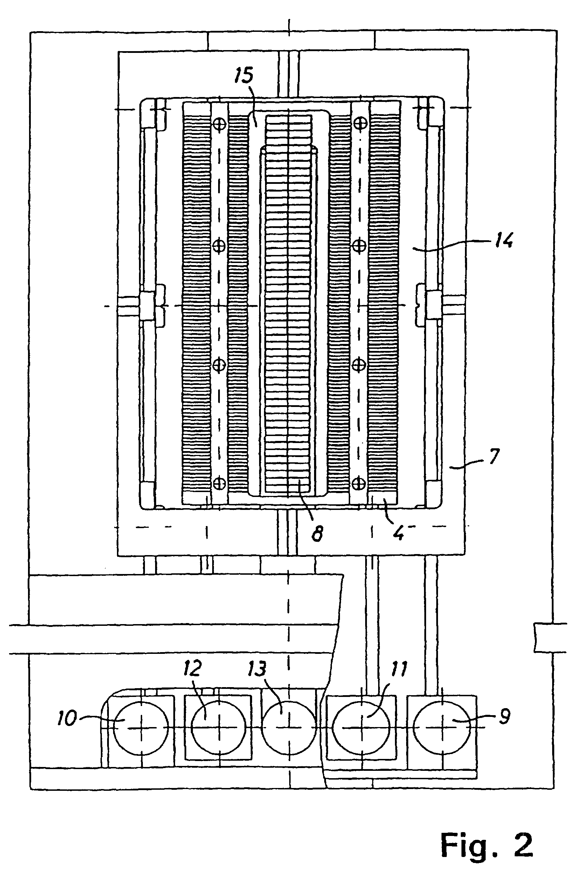

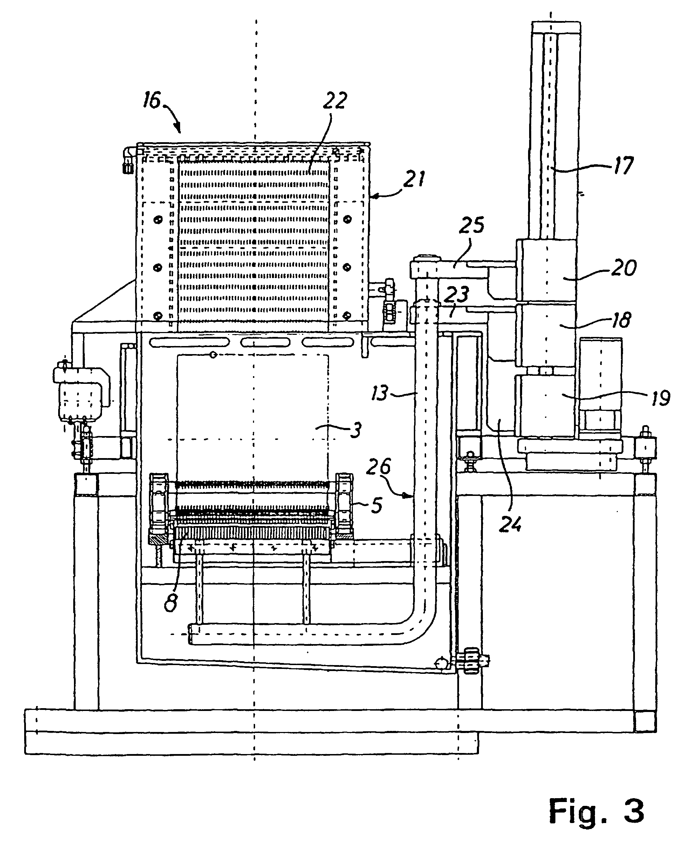

In der Fig. 1 ist ein Behälter 1 mit einem darin befindlichen Behandlungsfluid 2 dargestellt. Substrate 3, beispielsweise Halbleiterwafer mit einem Durchmesser von 300 mm, befinden sich in dem Behälter 1 für eine chemische Naßbehandlung. Die Substrate 3 werden von einer Aufnahmevorrichtung 4 für die Substrate 3 in dem Behälter 1 getragen. Die Substrate 3 liegen nicht mehr auf dem Substratträger 5 auf. In Fig. 1 ist dies daran zu erkennen, daß die Substratkanten von dem Auflagenbereich 6 (vgl. die gestrichelte Linie) des Substratträgers 5 beabstandet sind. Der Substratträger 5 wird von einer Substratträger-Aufnahme 7 im Behälter 1 getragen. Ferner ist in dem Behälter 1 eine messerartige Aushubvorrichtung 8 zum Ausheben der Substrate 3 aus dem Behälter 1 vorgesehen. Zur Verbindung der Aufnahme 7 für den substratträger 5 mit einer anhand von den Fig. 2 und 3 noch zu beschreibenden Transportvorrichtung sind vertikale Stangen 9, 10 vorgesehen. Die Aufnahmevorrichtung 4 ist mit vertikalen Stangen 11, 12 verbunden. Eine messerartige Aushubvorrichtung 8 mit einem in Fig. 1 nicht dargestellten Transportmechanismus ist mit einem vertikalen Abschnitt 13 einer gebogenen Stange verbunden.

Fig. 2 zeigt eine Ansicht von oben auf den in Fig. 1 dargestellten Behälter 1 der Fig. 1, wobei für eine bessere Übersicht die Substrate 3 und der Substratträger 5 weggelassen sind. Man entnimmt der Fig. 2, daß die Aufnahme 7 für den in Fig. 2 nicht dargestellten Substratträger 5 eine rechteckige Öffnung 14 aufweist. Die Aufnahmevorrichtung 4 ist in der untersten Position innerhalb der Öffnung 14 der Aufnahme 7 angeordnet und durch diese durch die Aufnahme 7 in vertikaler Richtung bewegbar, um beispielsweise die Substrate aus dem in Fig. 2 nicht dargestellten Substratträger 5 auszuheben und zu übernehmen. Die Aufnahmevorrichtung 4 für die Substrate 3 besitzt einen rechteckigen Durchlaß 15, der schmaler als die rechteckige Öffnung 14 ausgebildet ist. Innerhalb des rechtekkigen Durchlasses 15 ist die messerartige Aushubvorrichtung 8 angeordnet und durch diesen hindurch in vertikaler Richtung bewegbar.

In Fig. 3 ist eine Querschnittsansicht eines Ausführungsbeispiels der erfindungsgemäßen Anlage 16 zur chemischen Behandlung dargestellt. Auf einer vertikalen Führung 17 sind ein erster Transportschlitten 18 für die Aufnahmevorrichtung 4, ein zweiter Transportschlitten 19 für die Aufnahme 7 des Substratträgers 5 und ein dritter Transportschlitten 20 für die messerartige Aushubvorrichtung 8 gleitbar angeordnet. Die Transportschlitten 18, 19, 20 werden von nicht gezeigten Antriebsmitteln entlang der Führung 17 in vertikaler Richtung bewegt. Zur starren verbindung des ersten Transportschlittens 18 mit der Aufnahmevorrichtung 4 für die Substrate 3 ist ein erster Arm 23 vorgesehen, der den ersten Transportschlitten 18 mit den vertikalen Stangen 11, 12 verbindet. Zur Verbindung des zweiten Transportschlittens 19 mit der Aufnahme 7 für den Substratträger 5 ist ein zweiter Arm 24 vorgesehen, der die zweiten Transportschlitten 19 mit den vertikalen Stangen 9, 10 verbindet. Zur Verbindung des dritten Transportschlittens 20 mit der messerartigen Aushubvorrichtung 8 ist ein dritter Transportarm 25 vorgesehen, der den dritten Transportschlitten 20 mit dem vertikalen Abschnitt 13 der gebogenen Stange 26 verbindet, die die Aushubvorrichtung 8 trägt.

Der erste Transportschlitten 18 ist mit dem zweiten Transportschlitten 19 über einen nicht gezeigten Pneumatikzylinder verbunden. Da der erste Transportschlitten 18 starr mit der Aufnahmevorrichtung 4 für die Substrate 3 verbunden ist und der zweite Transportschlitten 19 starr mit der Aufnahme 7 für den Substratträger 5 verbunden ist, wird durch ein Betätigen und Ausfahren des Pneumatikzylinders das Substrat 3 in die in der Fig. 1 dargestellte Position bewegt. Die Substrate 3 liegen dann nicht mehr in dem Substratträger 5 auf und werden zentriert in der Aufnahmevorrichtung 4 aufgenommen und gehalten.

Über dem Behälter 1 ist eine entfernbare Haube 21 angeordnet, die an ihren gegenüberliegenden Innenseiten den Schlitzen der Aufnahmevorrichtung 4 für die Substrate 3 entsprechende Führungsschlitze 22 aufweisen.

Der erste Transportschlitten 18 oder der zweite Transportschlitten 19 ist mit dem dritten Transportschlitten 20 über eine (nicht dargestellte) Gelenkverbindung, die an einer (nicht dargestellten) Kurvenscheibe abläuft, gekoppelt, um beim Ausfahren der Substrate 3 für eine Verlangsamung der Aufnahmevorrichtung 4 relativ zu der messerartigen Aushubvorrichtung 8 zu sorgen. Die Aufnahmevorrichtung 4 für die Substrate 3 wird relativ zu der messerartigen Aushubvorrichtung 8 abgebremst und wird von dieser zum Ausfahren der Substrate 3 aus dem Behälter 1 überholt.

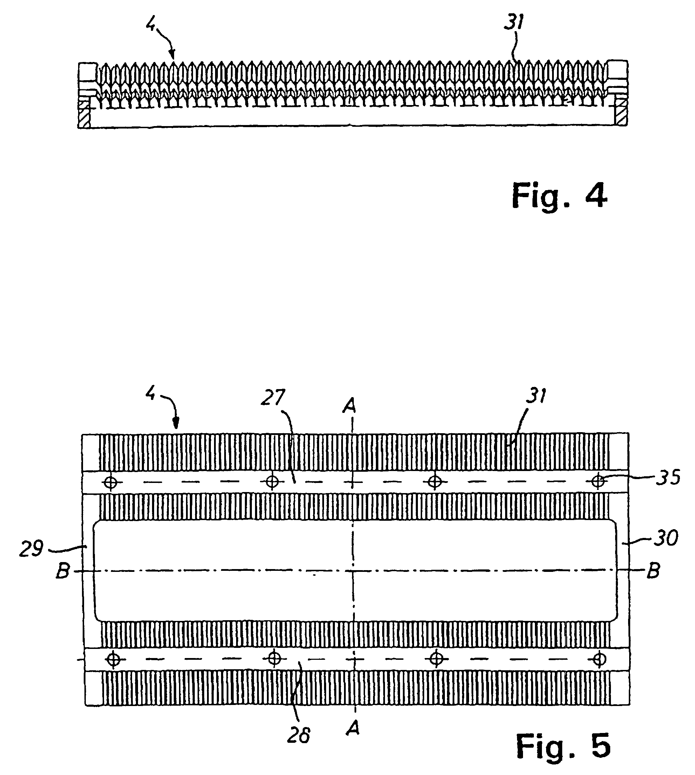

Unter Bezugnahme auf die Fig. 4 bis 9 wird die Aufnahmevorrichtung 4 für die'Substrate 3 im Detail beschrieben.

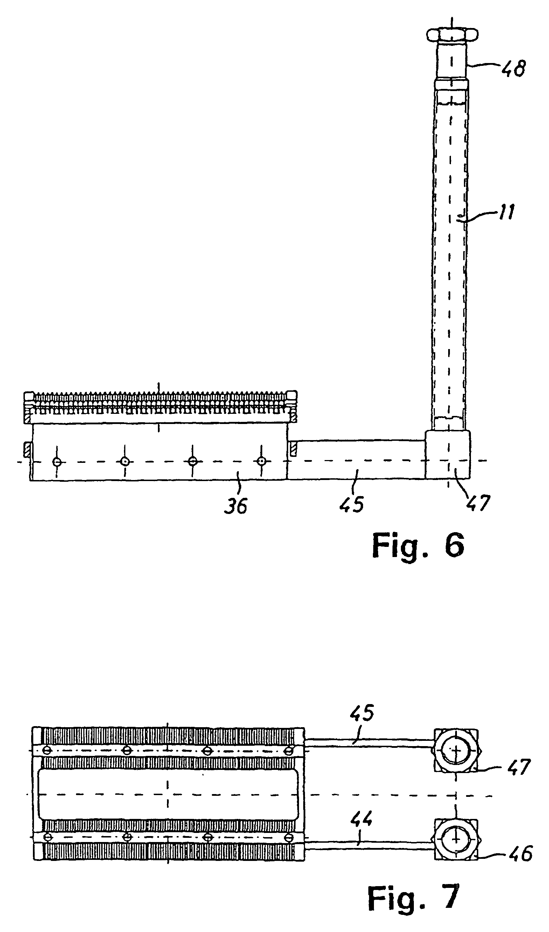

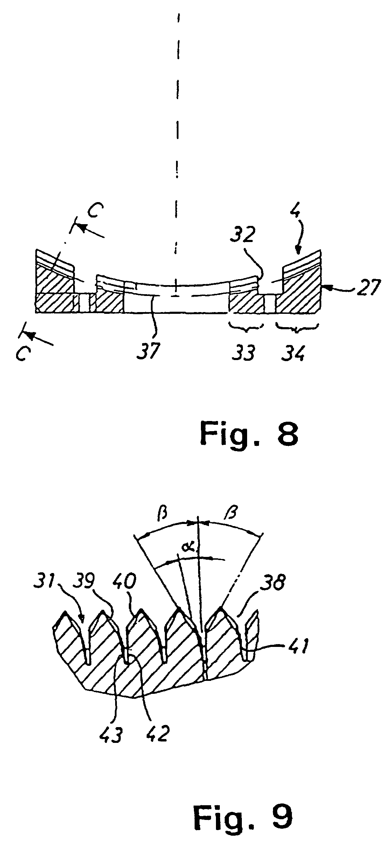

Aus Fig. 5 erkennt man, daß die Aufnahmevorrichtung 4 für die (nicht dargestellten) Substrate 3 die Form eines Rahmens besitzt. Die Aufnahmevorrichtung 4 ist symmetrisch zur Achse B-B, wie in Fig. 5 gezeigt, aufgebaut. Die Aufnahmevorrichtung 4 besitzt zwei gegenüberliegende Längsseiten 27, 28 und zwei kürzere gegenüberliegende Schmalseiten 29, 30. Auf den Längsseiten 27, 28 ist eine Reihe von (Quer-)Schlitzen 31 vorgesehen. Aufgrund dieser Ausbildung kann die Aufnahmevorrichtung 4 auch als Zentrierkamm bezeichnet werden. Unter Bezugnahme auf Fig. 8 wird der Querschnitt der einen Längsseite 27 der Aufnahmevorrichtung 4 näher beschrieben. In Fig. 8 ist ein Querschnitt durch einen Schlitz 31 dargestellt. Die Längsseite 27 wird durch eine Nut 32, die sich entlang der gesamten Länge der Längsseite 27 erstreckt, in einen inneren Abschnitt 33 und einen äußeren Abschnitt 34 geteilt. In der Nut 32 sind Senkbohrungen 35 vorgesehen, um die Aufnahmevorrichtung 4 mit einer darunterliegenden in Fig. 6 erkennbaren Tragstruktur 36 zu verbinden. Während die Unterseite der Längsseite 27 waagrecht ausgebildet ist, besitzt die Oberseite der Längsseite 27 eine den Substraträndern 3 komplementäre Form. Dies gilt ebenfalls für die Böden der Schlitze 31. In Fig. 8 ist ein Randkreissegment eines eingesetzten Substrats 3 schematisch durch die gestrichelte Linie 37 angedeutet. Die Schlitzböden bilden daher einen Teil eines Kreisumfangs, der dem Radius der Substrate 3 entspricht.

Unter Bezugnahme auf Fig. 9 wird die Ausbildung der Schlitze 31 im Detail beschrieben. Die Schlitze 31 besitzen einen ersten zu der Schlitzöffnung hinweisenden Abschnitt 38, in dem die Schlitzwände 39, 40 jeweils zur Vertikalen um einen Winkel β von beispielsweise 30° geneigt sind. Ein zweiter Abschnitt 41, der zu dem Schlitzboden hinweist, besitzt eine vertikale Wand 42 und eine um einen Winkel α von z. B. 10° zu der vertikalen Wand 42 geneigte Wand 43. Die Struktur des zweiten Abschnitts 41 ermöglicht eine Klemmung der Substrate 3 und sorgt für deren notwendige Zentrierung und Ausrichtung.

Aus Fig. 6 und 7 ist ersichtlich, daß die Tragstruktur 36 über vertikale Stangen 44, 45 mit würfelförmigen Kopplungselementen 46, 47 verbunden ist. Die würfelförmigen Kopplungelemente 46, 47 verbinden die horizontalen Stangen 44, 45 mit den vertikalen Stangen 11, 12. Die vertikalen Stangen 11, 12 besitzen an dem den Kopplungselementen 46, 47 abgewandten Ende jeweils ein Absatz 48, in die der erste Transportarm 23 des ersten Transportschlittens 18 eingreifen kann, um den ersten Transportschlitten 18 starr und mit den vertikalen Stangen 11, 12 und damit mit der Aufnahmevorrichtung 4 für die Substrate 3 zu verbinden.

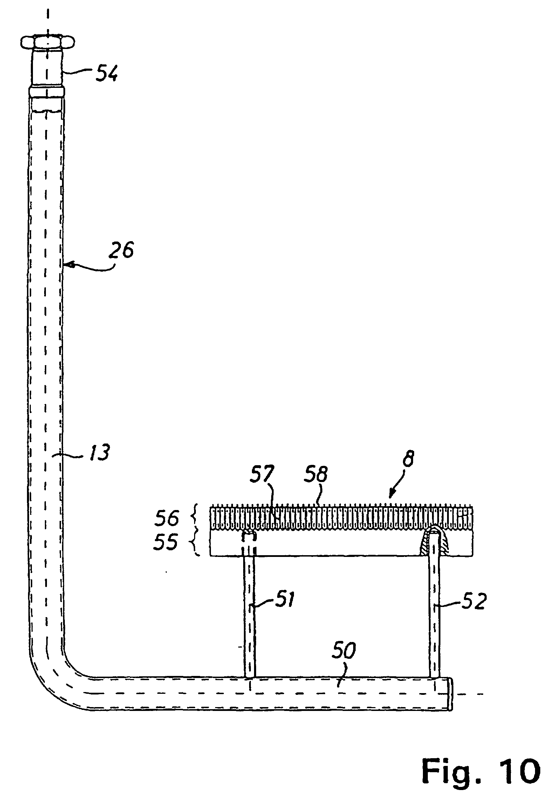

In Fig. 10 ist ein Querschnitt der messerartigen Aushubvorrichtung 8 mit einem damit verbundenen Hubmechanismus dargestellt. Zur Verbindung der messerartigen Aushubvorrichtung 8 mit dem dritten Transportschlitten 20 ist ein gebogenes Rohr 26 vorgesehen, das einen vertikalen Abschnitt 13 und einen horizontalen Abschnitt 50 aufweist. Die messerartige Aushubvorrichtung 8 ist mit dem horizontalen Abschnitt 50 der rechtwinklig gebogenen Stange 26 über zwei vertikale Stäbe 51, 52 verbunden. Am oberen Ende der gebogenen Stange 26 ist ein Absatz 54 vorgesehen, die dem Absatz 48 entspricht, und in die der dritte Transportarm 25 eingreifen kann, um die messerartige Aushubvorrichtung 8 mit dem dritten Transportschlitten 20 starr zu verbinden. Die messerartige Aushubvorrichtung 8 weist einen quaderförmigen Abschnitt 55 und einen zugespitzten Abschnitt 56 auf. Der zugespitzte Abschnitt 56 weist spitz zulaufende Seiten auf, von denen nur eine Seite 57 in Fig. 10 erkennbar ist. Die spitz zulaufenden Seiten weisen Schlitze oder Rillen 58 auf, um die Substrate 3 getrennt voneinander auszuheben. Die Schlitze 58 sind entsprechend den Querschlitzen 31 der AufnahmeVorrichtung 4 für die Substrate 3 und den Führungsschlitzen 22 der Haube 21 ausgerichtet bzw. angeordnet.

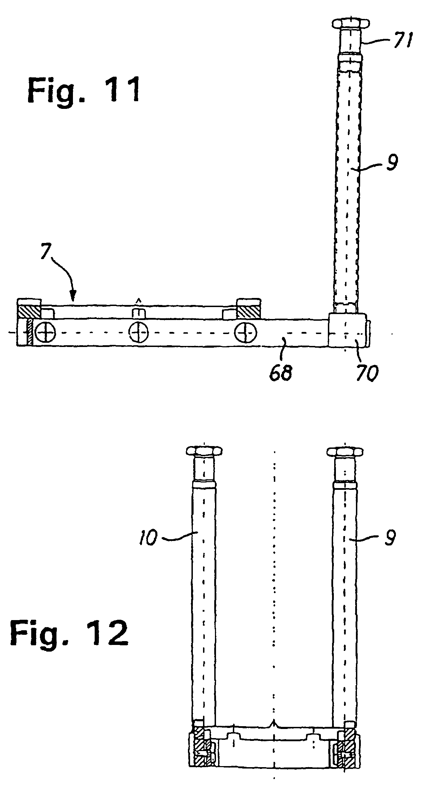

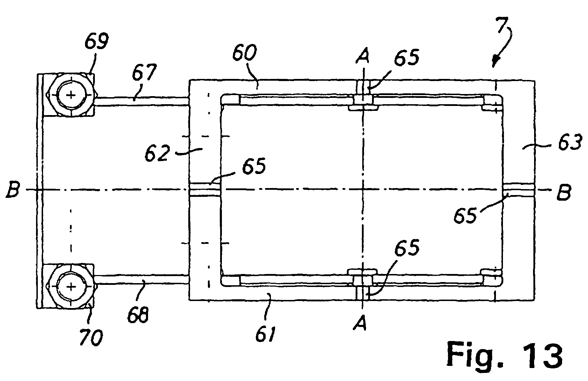

Unter Bezugnahme auf die Fig. 11 bis 13 wird die Aufnahme 7 für den Substratträger 5 im Detail beschrieben. Aus Fig. 13 erkennt man, daß die Aufnahme 7 die Form eines Rahmens besitzt. Die Aufnahme 7 ist symmetrisch zu der in Fig. 13 eingezeichneten Linie B-B aufgebaut. Die Aufnahme 7 weist zwei gegenüberliegende Längsseiten 60, 61 und zwei gegenüberliegende Breitseiten 62, 63 auf. In der Mitte der Seiten 60, 61, 62 und 63 sind jeweils Zentrierkerben 65 vorgesehen, um den nicht dargestellten Substratträger 5 auf der Aufnahme 7 auszurichten. Zwei vertikale Stangen 67, 68 unterstützen die Aufnahme 7 unter den Längsseiten 60 und 61. Die horizontalen Stangen 67, 68 sind über würfelförmige Kopplungselemente 69, 70 mit den vertikalen Stangen 9, 10 verbunden. An dem den würfelförmigen Kopplungselementen 69, 70 gegenüberliegenden Enden weisen die vertikalen Stangen 9, 10 jeweils Absätze 71 auf, die den Nuten 48 und 54 entsprechen. Die Absätze 71 sind vorgesehen, um einen Eingriff des zweiten Transportarms 24 zu ermöglichen, und den zweiten Transportschlitten 19 starr mit der Aufnahme 7 zu verbinden.

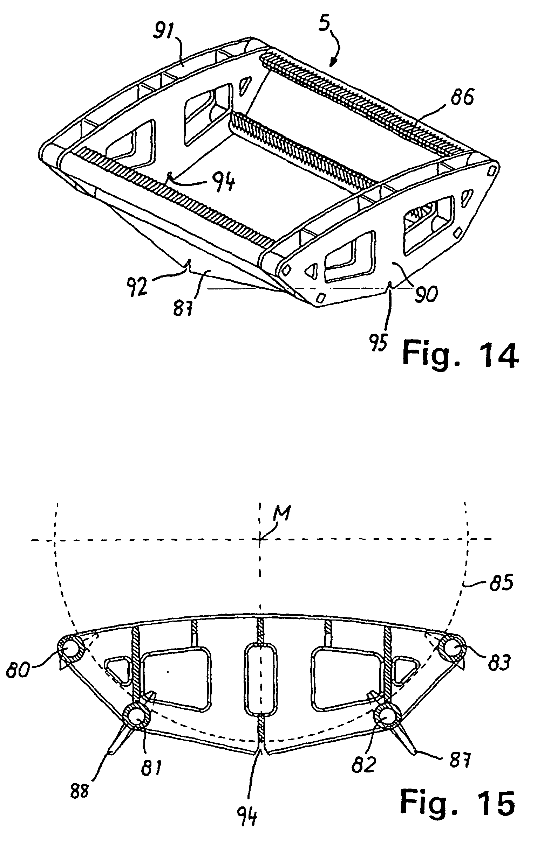

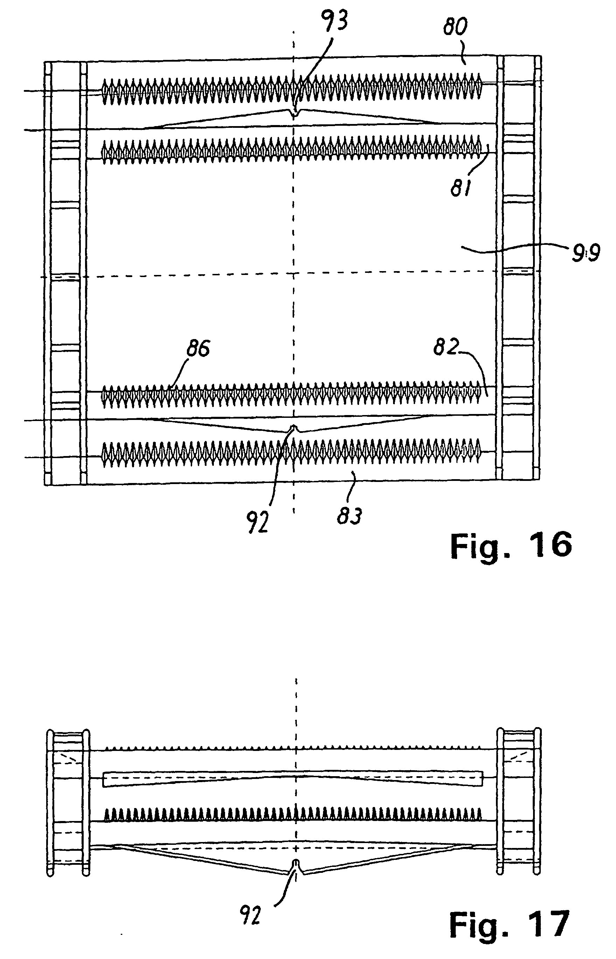

Unter Bezugnahme auf die Fig. 14 bis 17 wird der Substratträger 5 im Detail beschrieben.

Der Substratträger 5 weist vier Stäbe 80, 81, 82, 83 auf. Die Stabachsen sind auf einem Kreisbogen angeordnet, der konzentrisch zu dem in Fig. 15 durch die gestrichelte Linie 85 angedeuteten Außenumfang der Substrate 3 ist. An den Stäben 80 bis 83 sind zu dem Mittelpunkt des Substrats 1 hinweisende Schlitze 86 ausgebildet, wobei die Böden der Schlitze 86 auf einem Kreisbogen liegen, der durch die Linie 85 angedeutet ist und den Substratrand darstellt. Die Stäbe 80 bis 83 werden durch zwei gegenüberliegende profilartig ausgebildete Seitentragelemente 90, 91 gehalten. Die Seitentragelemente 90, 91 und die Stäbe 81, 82 besitzen in ihrer Mitte Zentriernuten 92, 93, 94, 95, in die Zentrierkeile 65 der Aufnahmevor-richtung 7 für den Substratträger eingreifen. Die Schlitze 86 sind zu den Schlitzen 31 der Aufnahmevorrichtung 4 für die Substrate 3, den Schlitzen 58 der messerartigen Aushubvorrichtung 8 und den schlitzen 22 der Haube 21 ausgerichtet ausgebildet. Die inneren Stäbe 81, 82 definieren eine rechteckige Öffnung 99, durch die die Aufnahmevorrichtung 4 für die Substrate 3 und die messerartige Aushubvorrichtung 8 in vertikaler Richtung bewegbar sind.

Durch die am Substratträger 5 in Längs- und in Querrichtung jeweils mittig ausgebildeten Auflagestellen zur Auflage auf der Aufnahmevorrichtung 7 in dem Behandlungsbehälter 1 der Anlage behält der Substratträger auch dann eine exakt definierte Position bei, wenn sich die Abmessungen des Substratträgers 5 auf Grund von bei den Verarbeitungsprozessen auftretenden Temperaturschwankungen ändern. Diese genaue Positionierung der Substratscheiben ist für eine unproblematische Handhabbarkeit der Substratscheiben und zur Vermeidung von Bruchgefahr vorteilhaft. Alternativ ist eine Anordnung möglich, bei der nur jeweils zwei Auflagestellen des Substratträgers in Längsrichtung oder in Querrichtung mittig ausgebildet sind und die weiteren Auflagepunkte als auf dem Behälterboden verschiebbare Auflagepunkte ausgebildet sind, so daß die Positionierung des Substratträgers bei Temperaturschwankungen ebenfalls unverändert bleibt.

Die als Profilteile ausgebildeten Seitentragelemente 90, 91 weisen, wie aus den Fig. 14 bis 17 zu entnehmen ist, Querstege auf, unter welche zum "Handling" des Substratträgers, d. h. zum Herausnehmen und Absetzen des Substratträgers 5 in den Behälter 1 eingegriffen werden kann. Dadurch entfallen außen an den Seitentragelementen angebrachte Längsträger, wie sie etwa in der deutschen Patentanmeldung DE-A-44 28 169 beschrieben sind. Dadurch wird der Substratträger insgesamt kompakter und besser handhabbar.

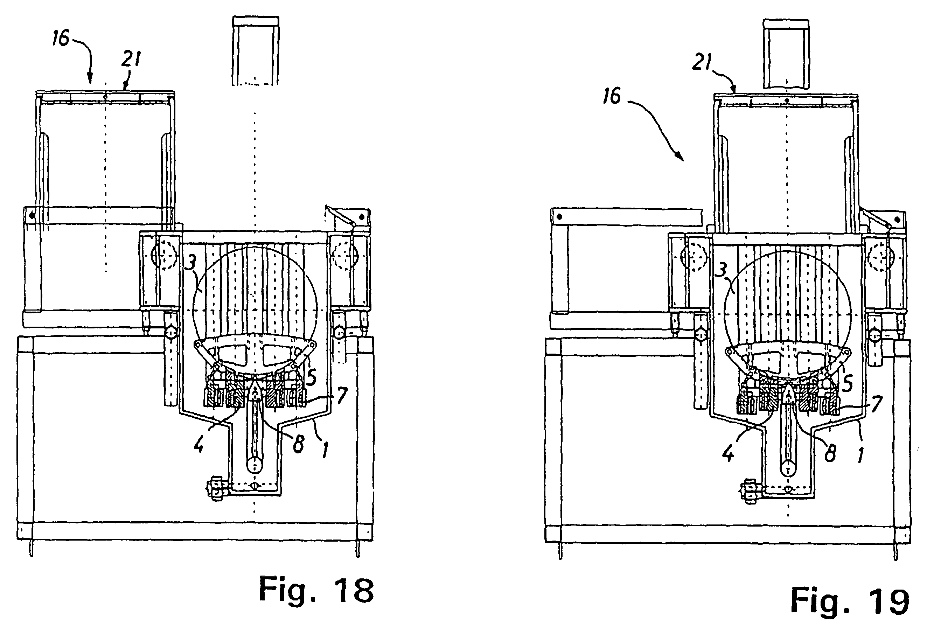

In den Fig. 18 bis 23 ist eine Querschnittsansicht der Anlage 17 in verschiedenen Prozeßstufen gezeigt. Unter Bezugnahme auf die Fig. 18 bis 24 wird das Verfahren für die Substrate 1 im Detail beschrieben.

Aus Fig. 18 erkennt man, daß der Substratträger 5 mit den darin befindlichen Substraten 3 auf die Aufnahme 7 für den Substratträger 5 in den Behälter 1 eingesetzt wurde. Durch eine Betätigung eines nicht gezeigten Pneumatikzylinders werden die Transportschlitten 18, 19 um etwa 10 mm getrennt, und vorzugsweise wird die Aufnahme 7 dabei um 10 mm nach unten gefahren. Dadurch werden-die Substrate 3 aus dem Substratträger 5 ausgehoben und sitzen in der Aufnahmevorrichtung 4 für die Substrate 3 auf, wie am besten aus der Vergrößerung gemäß Fig. 1 ersichtlich ist.

Fig. 19 stellt den Beginn des Trocknungsprozesses dar. Dazu wurde die Haube 21 über den Behälter 1 bewegt und eine Dampfatmosphäre innerhalb des Innenraums der Haube 21 erzeugt, wobei der Dampf nicht auf den Substraten 3 kondensiert und mit dem Behandlungsfluid 2 mischbar ist, und wobei das Gemisch aus Behandlungsfluid 2 und Dampf eine geringere Oberflächenspannung wie das Behandlungsfluid 2 besitzt. Die Einzelheiten eines derartigen Trocknungsverfahrens können der eingangs genannten europäischen Patentanmeldung EP-A-0 385 536 entnommen werden.

Durch eine entsprechende Bewegung der gekoppelten Transportschlitten 18, 19 und 20 fahren die messerartige Aushubvorrichtung 8, und die Aufnahmevorrichtung 4 für die Substrate 30 und der Substratträger 5 gemeinsam nach oben.

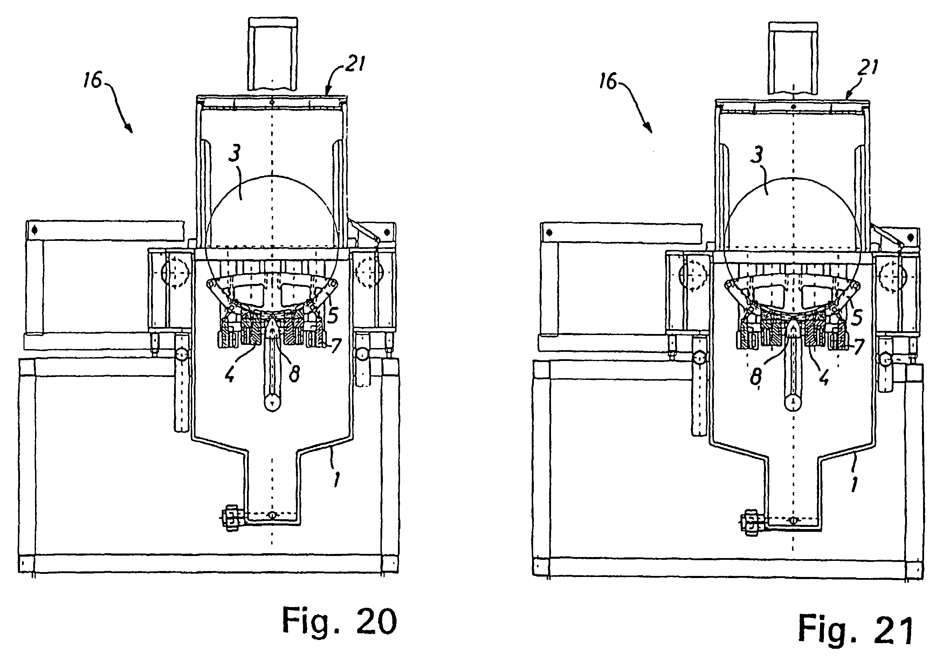

In Fig. 20 ist eine Situation dargestellt, in der die Aufnahmevorrichtung 4 für die Substrate relativ zu der messerartigen Aushubvorrichtung 8 abgebremst wird. Dieser Differenzhub wird durch die zwischen den Transportschlitten 18 oder 19 und dem dritten Transportschlitten 20 vorhandene Gelenkverbindung realisiert.

In Fig. 21 ist eine Situation dargestellt, in der die Aufnahmevorrichtung 4 für die Substrate 3 zum Stillstand gekommen ist und die Substrate 3 weiter nach oben bewegt und dabei lediglich durch die messerartige Aushubvorrichtung 8 gehalten werden. Die Substrate 3 gleiten dabei in die Führungen 22 der Haube 21 ein.

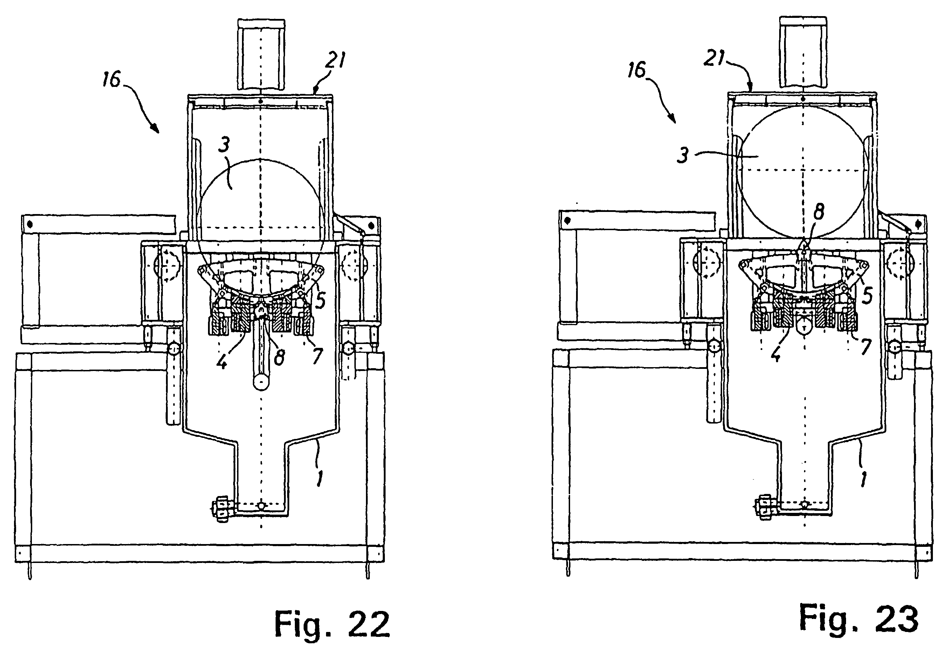

Der Fig. 22 entnimmt man, daß sich die Aufnahme 7 für den Substratträger 5 und damit der Substratträger 5 nicht weiter nach oben bewegt. Der Substratträger 5 bleibt somit vollständig in dem Behandlungsfluid 2 des Behälters 1, während die Substrate 3 weiter durch die messerartige Aushubvorrichtung 8 aus dem Behandlungsfluid 2 gehoben werden.

In Fig. 23 ist eine Situation dargestellt, in der die Substrate 3 vollständig aus dem Behandlungsfluid 2 ausgehoben sind. Die Substrate 3 befinden sich vollständig in der Haube 21 und werden von den seitlichen Führungen 22 der Haube 21 geführt und von der messerartigen Aushuborrichtung 8, die über den Flüssigkeitsspiegel des Behandlungsfluids 2 in dem Behälter 1 ausgefahren ist, getragen. Der Substratträger 5 wird durch Ablassen des Behandlungsfluids getrocknet. Durch eine erneute Betätigung des Pneumatikzylinders in entgegengesetzter Hubrichtung wird die Aufnahme 7 für den Substratträger 5 um etwa 10 mm angehoben. Die Substrate 3 werden durch Absenken der messerartigen Aushubvorrichtung 8 in den getrockneten Substratträger entladen.

Die Substrate werden also nach dem Trocknungsvorgang nicht mehr in die Substrat-Aufnahmevorrichtung gebracht. Dadurch ist es auch nicht erforderlich, daß ihre Ausrichtungsschlitze trocken sein müssen, so daß sie im Hinblick auf die Zentrierung und Halterung der Substrate und nicht im Hinblick auf eine schnelle Trocknung optimiert sein können, gerade im Gegensatz zu den Schlitzen der Substratträger.

Schließlich wird die Haube geöffnet und die in dem ebenfalls getrockneten Subtratträger befindlichen getrockneten Substrate werden mit diesem für eine weitere_Behandlung entfernt.

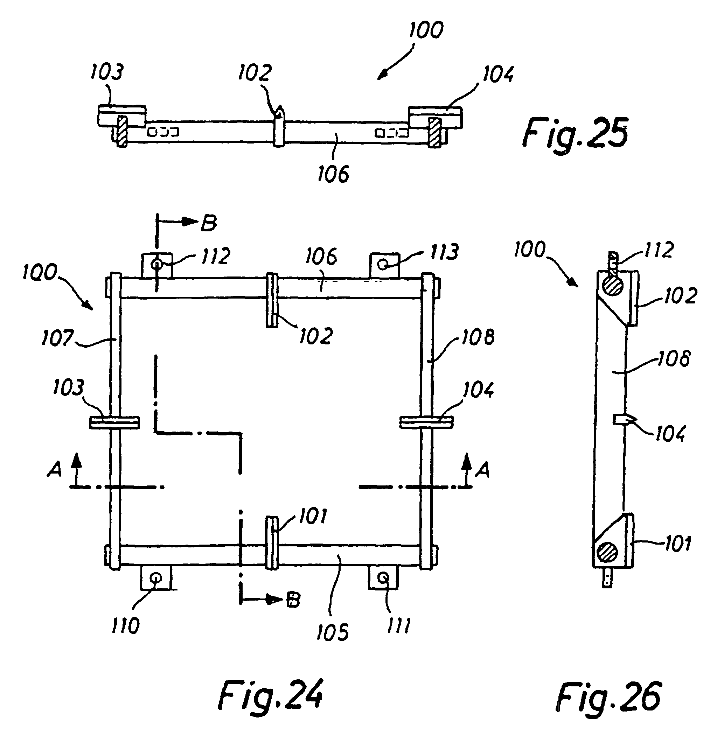

Eine Adaptervorrichtung zur Aufnahme verschiedener Substratträger mit unterschiedlichen Größen in einem Behandlungsbehälter der Anlage zur Bearbeitung von Substraten ist in den Fig. 24 bis 26 dargestellt.

Der Adapter besteht aus zwei parallelen zueinander beabstandeten Längsbalken 105, 106, die durch zwei senkrecht dazu angeordnete Querbalken 107, 108 verbunden sind. An den Längsbalken sind flache Halteglieder ausgebildet, die Fixierungslöcher 110-113 aufweisen, in die im Behälterboden des Behandlungsbehälters ausgebildete Fixierungsstifte eingreifen. Der Adapter weist Auflagestellen 101-104 zum Auflegen eines Substratträgers auf. Die Auflegestellen 101-104 sind in Längs- und Querrichtung mittig angeordnet und als Zentrierkeile ausgebildet, auf die die als Zentriernuten ausgebildeten Aufsetzstellen eines erfindungsgemäßen Substratträgers aufgesetzt werden können.

Die Auflagestellen verschiedener Adapter sind entsprechend der Größe verschiedener Substratträger unterschiedlich ausgebildet, während die Fixierungslöcher 110-113 verschiedener Adapter immer die gleichen Position aufweisen. So ist es möglich, in einen Behandlungsbehälter mittels unterschiedlicher Adapter mehrere Substratträger unterschiedlicher Größen einzusetzen. Ein Auswechseln des Behandlungsbehälters ist somit nicht erforderlich.

Die Erfindung wurde anhand eines bevorzugten Ausführungsbeispiels beschrieben. Dem Fachmann sind jedoch zahlreiche Abwandlungen und Ausgestaltungen möglich, ohne daß dadurch der der Erfindung zugrundeliegende Gedanke verlassen wird. Beispielsweise könnte ein abgewandelter Typ von Substratträger verwendet werden, der ebenfalls so ausgebildet ist, daß die Substrate von unten durch die Aufnahmevorrichtung für die Substrate herausgehoben werden können. Auch wäre es möglich, direkt beim Einsetzen des Substratträgers mit den darin enthaltenen Substraten durch geeignetes vorheriges Absenken der Aufnahmevorrichtung für den Substratträger die Substrate aus dem Substratträger auszuheben. Die Aufnahmevorrichtung für die Substrate könnte ebenfalls aus mit Schlitzen versehenen Rundstäben - ähnlich dem Substratträger - aufgebaut sein.

## Patentansprüche

1. Anlage (16) zur Naßbehandlung von Substraten (3) in einem ein Behandlungsfluid (2) enthaltenden Behälter (1), mit
- einem Behälter (1 ),
- einem Substratträger (5) zum Einbringen der Substrate (3) in den Behälter,
- einer Substratträger-Aufnahme (7) für den Substratträger im Behälter (1),
- einer Aufnahmevorrichtung (4) für die Substrate (3) im Behälter (1), und
- einer messerartigen Aushubvorrichtung (8) für die Substrate (3) im Behälter (1 ), wobei die Substratträger-Aufnahme (7), die Aufnahmevorrichtung (4) und die Aushubvorrichtung (8) im Behälter relativ zueinander in vertikaler Richtung bewegbar sind, und
wobei der Substratträger (5) und die Substratträger-Aufnahme (7) eine Öffnung (99; 14) aufweist, durch die die Aufnahmevorrichtung (4) und die messerartige Aushubvorrichtung (8) bewegbar sind, und die Aufnahmevorrichtung (4) einen Durchlaß (15) aufweist, durch den die Aushubvorrichtung (8) bewegbar ist.

2. Anlage (16) nach Anspruch 1, **gekennzeichnet durch** einen ersten Transportschlitten (18) für die Aufnahmevorrichtung (4) und einen zweiten Transportschlitten (19) für den Substratträger (5).

3. Anlage (16) nach Anspruch 2, **dadurch gekennzeichnet, daß** der zweite Transportschlitten (19) die Substratträger-Aufnahme (7) aufweist.

4. Anlage (16) nach einem der Ansprüche 2 oder 3, **dadurch gekennzeichnet, daß** der erste und der zweite Transportschlitten (18,19) relativ zueinander bewegbar sind.

5. Anlage (16) nach einem der Ansprüche 2 bis 4, **dadurch gekennzeichnet, daß** die ersten und zweiten Transportschlitten (18,19) für ein gemeinsames Einund Ausfahren in bzw. aus dem Behälter (1) miteinander verbunden sind.

6. Anlage (16) nach einem der Ansprüche 1 bis 5, **dadurch gekennzeichnet, daß** für die Relativbewegung eine Antriebsvorrichtung, vorzugsweise ein Pneumatikzylinder, vorgesehen ist.

7. Anlage (16) nach einem der vorhergehenden Ansprüche, **gekennzeichnet durch** eine Antriebsvorrichtung für eine vertikale Bewegung der Aufnahmevorrichtung (4) und/oder der Substratträger-Aufnahme (7).

8. Anlage (16) nach einem der vorhergehenden Ansprüche, **dadurch gekennzeichnet, daß** die Aufnahmevorrichtung (4) Schlitze (31) aufweist.

9. Anlage (16) nach Anspruch 8, **dadurch gekennzeichnet, daß** die Schlitze (31) komplementär zur Kantenform der Substrate (3) ausgebildet sind.

10. Anlage (16) nach Anspruch 8 oder 9, **dadurch gekennzeichnet, daß** die Breite der Schlitze (31) von der Schlitzöffnung zu dem Schlitzboden hin abnimmt.

11. Anlage (16) nach Anspruch 10, **dadurch gekennzeichnet, daß** eine Wand (42) eines Schlitzes (31) vertikal und eine zweite Wand (43) des Schlitzes (31) um einen ersten vorbestimmten Winkel (α) zur Vertikalen geneigt ist.

12. Anlage (16) nach einem der Ansprüche 8 bis 11, **dadurch gekennzeichnet, daß** die Schlitzwände (38, 39) im Schlitzöffnungsbereich (38) einen zweiten vorbestimmten Winkel (β) mit der Vertikalen einschließen.

13. Anlage (16) nach Anspruch 11 oder 12, **dadurch gekennzeichnet, daß** der erste vorbestimmte Winkel (α) kleiner als der zweite vorbestimmte Winkel (β) ist.

14. Anlage (16) nach einem der vorhergehenden Ansprüche, **dadurch gekennzeichnet, daß** die Aushubvorrichtung (8) eine messerartige Leiste ist.

15. Anlage (16) nach einem der vorhergehenden Ansprüche, **gekennzeichnet durch** einen dritten Transportschlitten (20) für die Aushubvorrichtung (8).

16. Anlage (16) nach Anspruch 15 zusammen mit Anspruch 2, **dadurch gekennzeichnet, daß** zur Verbindung des ersten (18) oder des zweiten (19) Transportschlittens mit dem dritten Transportschlitten (20) eine Gelenkverbindung vorgesehen ist.

17. Anlage nach Anspruch 16 oder 15 zusammen mit Anspruch 2, **dadurch gekennzeichnet, daß** die Transpörtschlitten (18,19,20) auf einer Führungsstange gleitbar angeordnet sind.

18. Anlage (16) nach einem der vorhergehenden Ansprüche, **dadurch gekennzeichnet, daß** die Anlage (16) eine über dem Behälter (1) aufsetzbare Haube (21) aufweist.

19. Anlage (16) nach Anspruch 18, **dadurch gekennzeichnet, daß** die Haube (21) an wenigstens einer Innenwand Führungsschlitze (22) für die Substrate (3) aufweist.

20. Anlage (16) nach Anspruch 18 oder 19, **dadurch gekennzeichnet, daß** in die Haube (21) ein Gas oder Gasgemisch zur Verbesserung eines Trocknungsvorgangs nach dem Marangoni-Verfahren einleitbar ist.

21. Anlage (16) nach einem der vorhergehenden Ansprüche, **dadurch gekennzeichnet, daß** die Anlage (16) zur chemischen Naßbehandlung der Substrate geeignet ist.

22. Anlage (16) nach einem der vorhergehenden Ansprüche, **dadurch gekennzeichnet, daß** die Anlage (16) zum Trocknen der Substrate (3) geeignet ist.

23. Anlage (16) nach einem der vorhergehenden Ansprüche, **dadurch gekennzeichnet, daß** die die Anlage zum Behandeln von Halbleiter-Wafern geeignet ist.

24. Anlage nach einem der vorhergehenden Ansprüche, **dadurch gekennzeichnet, daß** die Substratträger-Aufnahme (7) wenigstens zwei in Längs- und/oder Querrichtung des Substratträgers (5) mittig angeordnete Auflagestellen zum Auflegen eines Substratträgers aufweist.

25. Anlage nach Anspruch 24, **dadurch gekennzeichnet, daß** die Auflagestellen als Zentrierkeile ausgebildet sind.

26. Anlage nach einem der vorhergehenden Ansprüche, **dadurch gekennzeichnet, daß** der Substratträger wenigstens zwei eine Längsrichtung definierende Stäbe (80, 81, 82, 83) aufweist, die zwischen zwei quer dazu angeordneten Seitenplatten (90, 91) angeordnet sind, wobei der Träger (5) zum Aufsetzen im Behälter (1) wenigstens zwei in Längs- und/oder Querrichtung mittig angeordnete Aufsetzstellen (92, 93, 94, 95) aufweist.

27. Anlage nach Anspruch 26, **dadurch gekennzeichnet, daß** an jeder der Seitenplatten (90, 91) Aufsetzstellen (94, 95) mittig angeordnet sind.

28. Anlage nach Anspruch 26 oder 27, **dadurch gekennzeichnet, daß** an den zwei längs angeordneten Stäben (81, 82) Aufsetzstellen (92, 93) mittig ausgebildet sind.

29. Anlage nach einem der Ansprüche 26 oder 27, **dadurch gekennzeichnet, daß** Aufsetzstellen (92, 93) an zwei von den längs angeordneten Stäben (81, 82) schräg nach unten weisenden Abstützteilen (87, 88) mittig ausgebildet sind.

30. Anlage nach einem der Ansprüche 26 bis 29, **dadurch gekennzeichnet, daß** die Aufsetzstellen (92, 93, 94, 95) als Ausnehmungen ausgebildet sind, die auf entsprechende im Behälter ausgebildete Vorsprünge aufsetzbar sind.

31. Anlage nach Anspruch 30, **dadurch gekennzeichnet, daß** die Ausnehmungen (92, 93, 94, 95) als Zentriernuten ausgebildet sind, in die im Behälter (1) ausgebildete Zentrierkeile eingreifbar sind.

32. Anlage nach einem der Ansprüche 26 bis 31, **dadurch gekennzeichnet, daß** die Seitenplatten (90, 91) als Profilteile ausgebildet sind.

33. Anlage nach Anspruch 32, **dadurch gekennzeichnet, daß** die als Profilteile ausgebildeten Seitenplatten (90, 91) doppelwandig mit Querstegen ausgebildet sind.

34. Anlage nach einem der Ansprüche 26 bis 33, **dadurch gekennzeichnet, daß** an den wenigstens zwei längs angeordneten Stäben (80, 81, 82, 83) Querschlitze (86) zur Halterung der Substrate vorgesehen sind.

35. Anlage nach Anspruch 34, **dadurch gekennzeichnet, daß** die Querschlitze (86) zwischen zueinander beabstandeten, sich von den Stäben (80, 81, 82, 83) radial zum Zentrum der gehaltenen Substrate (85) erstrekkenden flachen Vorsprüngen ausgebildet sind.

36. Anlage nach einem der vorhergehenden Ansprüche, **gekennzeichnet durch** wenigstens einen Adapter (100), der in den Behälter (1) einsetzbar ist und Auflagestellen (101-104) zum Auflegen des Substratträgers (5) aufweist.

37. Anlage nach Anspruch 36, **gekennzeichnet durch** mehrere Adapter (100), die wahlweise zur Aufnahme von Substratträgern (5) verschiedener Größe und/oder Ausbildung in den Behälter (1) einsetzbar sind.

38. Anlage nach einem der Ansprüche 36 oder 37, **dadurch gekennzeichnet, daß** der Adapter (100) zwei in Längs.und/oder Querrichtung mittig angeordnete Auflagestellen (101-104) zum Auflegen des Substratträgers.

39. Anlage nach Anspruch 38, **dadurch gekennzeichnet, daß** die Auflagestellen (101-104) des Adapters als Zentrierkeile ausgebildet sind.

40. Anlage nach einem der Ansprüche 36 bis 39, **dadurch gekennzeichnet, daß** der Adapter (100) zwei parallele voneinander beabstandete Längsbalken (105, 106) aufweist, die durch zwei senkrecht dazu angeordnete Querbalken (107, 108) verbunden sind.

41. Anlage nach einem der Ansprüche 36 bis 40, **dadurch gekennzeichnet, daß** der Adapter (100) wenigstens zwei Fixierungslöcher (110-113) aufweist, in die im Behälterboden ausgebildete Fixierungsstifte eingreifen.

42. Verfahren zur Naßbehandlung von Substraten (3) in enier Anlage gemäß einem des Ansprüche 1 bis 41, bei dem die Substrate (3) im Substratträger (5) mittels der Substratträger-Aufnahme (7), in den Behälter (1) eingesetzt werden, die Substrate (3) von dem Substratträger (5) in die, in dem Behälter (1) angeordnete Aufnahmevorrichtung (4) für die Substrate (3) Übergeben werden, und die Substrate (3) mit der Aushubvorrichtung (8) aus dem Behälter (1) herausgehoben werden.

43. Verfahren nach Anspruch 42, **dadurch gekennzeichnet, daß** der Substratträger (5) und die Aufnahmevorrichtung (4) relativ zueinander bewegt werden.

44. Verfahren nach Anspruch 42 oder 43, **dadurch gekennzeichnet, daß** zum Übergeben der Substrate (3) von dem Substratträger (5) an die Aufnahmevorrichtung (4), der Substratträger (5) abgesenkt bzw. die Aufnahmevorrichtung (4) angehoben wird.

45. Verfahren nach einem der Ansprüche 42 bis 44, **dadurch gekennzeichnete daß** die Substrate (3) und der Substratträger (5) zum Trocknen getrennt werden.

46. Verfahren nach Anspruch 45, **dadurch gekennzeichnet,. daß** die Substrate (3) während des Herausfahrens in der Aufnahmevorrichtung (4) gehalten werden.

## Claims

1. Plant (16) for wet treatment of substrates (3) in a container (1) containing a treatment fluid (2), comprising a container (1), a substrate carrier (5) for introducing the substrates (3) into the container, a substrate carrier receptacle (7) for the substrate carrier in the container (1), a receiving device (4) for the substrates (3) in the container (1) and a knifelike lift-out device (8) for the substrates (3) in the container (1), wherein the substrate carrier receptacle (7), the receiving device (4) and the lift-out device (8) in the container are movable relative to one another in vertical direction and wherein the substrate carrier (5) and the substrate carrier receptacle (7) have an opening (99; 14) through which the receiving device (4) and the knifelike lift-out device (8) are movable and the receiving device (4) has a passage (15) through which the lift-out device (8) is movable.

2. Plant (16) according to claim 1, **characterised by** first transport slide (18) for the receiving device (4) and a second transport slide (19) for the substrate carrier (5).

3. Plant (16) according to claim 2, **characterised in that** the second transport slide (19) has the substrate carrier receptacle (7).

4. Plant (16) according to one of claims 2 and 3, **characterised in that** the first and second transport slides (18, 19) are movable relative to one another.

5. Plant (16) according to one of claims 2 to 4, **characterised in that** the first and second transport slides (18, 19) are connected together for common movement into and out of the container (1).

6. Plant (16) according to one of claims 1 to 5, **characterised in that** a drive device, preferably a pneumatic cylinder, is provided for the relative movement.

7. Plant (16) according to one of the preceding claims, **characterised by** a drive device for a vertical movement of the receiving device (4) and/or the substrate carrier receptacle (7).

8. Plant (16) according one of the preceding claims, **characterised in that** the receiving device (4) has slots (31).

9. Plant (16) according to claim 8, **characterised in that** the slots (31) are formed to be complementary to the edge shape of the substrates (3).

10. Plant (16) according to claim 8 or 9, **characterised in that** the width of the slots (31) decreases from the slot opening to the slot base.

11. Plant (16) according to claim 10, **characterised in that** one wall (42) of a slot (31) is vertical and a second wall (43) of the slot (31) is inclined relative to the vertical by a first predetermined angle (α).

12. Plant (16) according to one of claims 8 to 11, **characterised in that** the slot walls (38, 39) include a second predetermined angle (β) with the vertical in the region (38) of the slot opening.

13. Plant (16) according to claim 11 or 12, **characterised in that** the first predetermined angle (α) is smaller than the second predetermined angle (β).

14. Plant (16) according to one of the preceding claims, **characterised in that** the lift-out device (8) is a knifelike strip.

15. Plant (16) according to one of the preceding claims, **characterised by** a third transport slide (20) for the lift-out device (8).

16. Plant (16) according to claim 15 together with claim 2, **characterised in that** a pivot connection is provided for connection of the first transport slide (18) or the second transport slide (19) with the third transport slide (20).

17. Plant according to claim 16 or 15 together with claim 2, **characterised in that** the transport slides (18, 19, 20) are slidably arranged on a guide rod.

18. Plant (16) according to one of the preceding claims, **characterised in that** the plant (16) comprises a hood (21) placeable over the container (1).

19. Plant (16) according to claim 18, **characterised in that** the hood (21) has guide slots (22) for the substrates (3) at at least one inner wall.

20. Plant (16) according to claim 18 or 19, **characterised in that** a gas or gas mixture for improving a drying process according to the Marangoni method is introducible into the hood (21).

21. Plant (16) according to one of the preceding claims, **characterised in that** the plant (16) is suitable for chemical wet treatment of the substrates.

22. Plant (16) according to one the preceding claims, **characterised in that** the plant (16) is suitable for drying the substrates (3).

23. Plant (16) according to one of the preceding claims, **characterised in that** the plant is suitable for treatment of the semiconductor wafers.

24. Plant according to one of the preceding claims, **characterised in that** the substrate carrier receptacle (7) has at least two support locations, which are centrally arranged in longitudinal and/or transverse direction on the substrate carrier (5), for placement of a substrate carrier.

25. Plant according to claim 24, **characterised in that** the support locations are formed as centring wedges.

26. Plant according to one of the preceding claims, **characterised in that** the substrate carrier comprises at least two rods (80, 81, 82, 83) which define a longitudinal direction and which are arranged between two side plates (90, 91) arranged transversely thereto, wherein the carrier (5) has at least two deposit locations (92, 93, 94, 95), which are arranged centrally in longitudinal and/or transverse direction, for deposit in the container (1).

27. Plant according to claim 26, **characterised in that** deposit locations (94, 95) are centrally arranged at each of the side plates (90, 91).

28. Plant according to claim 26 or 27, **characterised in that** deposit locations (92, 93) are centrally formed at the two longitudinally arranged rods (81, 82).

29. Plant according to one of claims 26 and 27, **characterised in that** deposit locations (92, 93) are centrally formed at two support parts (87, 88) pointing obliquely downwardly from the longitudinally arranged rods (81, 82).

30. Plant according to one of claims 26 to 29, **characterised in that** the deposit locations (92, 93, 94, 95) are formed as recesses which can be placed on corresponding projections formed in the container.

31. Plant according to claim 30, **characterised in that** the recesses (92, 93, 94, 95) are formed as centring grooves in which centring wedges formed in the container (1) are engagable.

32. Plant according to one of claims 26 to 31, **characterised in that** the side plates (90, 91) are formed as profile parts.

33. Plant according to claim 32, **characterised in that** the side plates (90, 91) formed as profile parts are constructed to be double-walled with transverse webs.

34. Plant according to one of claims 26 to 33, **characterised in that** transverse slots (86) for holding the substrates are provided at the at least two longitudinally arranged rods (80, 81, 82, 83).

35. Plant according to claim 34, **characterised in that** the transverse slots (86) are formed between mutually spaced-apart flat projections extending radially from the rods (80, 81, 82, 83) to the centre of the held substrates (85).

36. Plant according to one of the preceding claims, **characterised by** at least one adapter (100) which is insertable in the container (1) and has support locations (101 to 104) for placement of the substrate carrier (5).

37. Plant according to claim 36 **characterised by** several adapters (100) which are selectably insertable in the container (1) for the reception of substrate carriers (5) of different size and/or construction.

38. Plant according to one of claims 36 and 37, **characterised in that** the adapter (100) has two support locations (101 to 104). which are arranged centrally in longitudinal and/or transverse direction, for placement of the substrate carrier.

39. Plant according to claim 38, **characterised in that** the support locations (101 to 104) of the adapter are formed as centring wedges.

40. Plant according to one of claims 36 o 39, **characterised in that** the adapter (100) comprises two mutually-spaced apart parallel longitudinal beams (105, 106) which are connected by two transverse beams (107, 108) arranged perpendicularly thereto.

41. Plant according to one of claims 36 to 40, **characterised in that** the adapter (100) has at least two fixing holes (110 to 113) in which fixing pins formed in the container base engage.

42. Method for wet treatment of substrates (3) in a plant according to one of claims 1 to 41, in which the substrates (3) in the substrate carrier (5) are inserted into the container (1) by means of a substrate carrier receptacle (7), the substrates (3) are transferred from the substrate carrier (5) to the receiving device (4), which is arranged in the container (1), for the substrates (3) and the substrates are lifted out of the container (1) by the lift-out device (8).

43. Method according to claim 42, **characterised in that** the substrate carrier (5) and the receiving device (4) are moved relative to one another.

44. Method according to claim 42 or 43, **characterised in that** for transfer of the substrates (3) from the substrate carrier (5) to the receiving device (4) the substrate carrier (5) is lowered or the receiving device (4) is raised.

45. Method according to one of claims 42 to 44, **characterised in that** the substrates (3) and the substrate carrier (5) are separated for the drying.

46. Method according to claim 45, **characterised in that** the substrates (3) are held in the receiving device (4) during the movement out.

## Revendications

1. Installation (16) pour le traitement par voie humide de substrats (3) dans un récipient (1) contenant un fluide de traitement (2), avec
- un récipient (1),
- un support de substrats (5) pour l'introduction des substrats (3) dans le récipient,
- un logement de support de substrats (7) pour le support de substrats dans le récipient (1),
- un dispositif de réception (4) pour les substrats (3) dans le récipient (1) et
- un dispositif de levage en forme de couteau (8) pour les substrats (3) dans le récipient (1), sachant que le logement de support de substrats (7), le dispositif de réception (4) et le dispositif de levage (8) sont mobiles verticalement les uns par rapport aux autres dans le récipient et
sachant que le support de substrats (5) et le logement de support de substrats (7) comportent une ouverture (99; 14) à travers laquelle le dispositif de réception (4) et le dispositif de levage en forme de couteau (8) peuvent être déplacés, et que le dispositif de réception (4) comporte une traversée (15), à travers laquelle le dispositif de levage (8) peut être déplacé.

2. Installation (16) selon la revendication 1, **caractérisée par** un premier traîneau de transport (18) pour le dispositif de réception (4) et une deuxième traîneau de transport (19) pour le support de substrats (5).

3. Installation (16) selon la revendication 2, **caractérisée en ce que** le deuxième traîneau de transport (19) comporte le logement de support de substrats (7) .

4. Installation (16) selon l'une des revendications 2 ou 3, **caractérisée en ce que** le premier et le deuxième traîneau de transport (18, 19) sont mobiles l'un par rapport à l'autre.

5. Installation (16) selon l'une quelconque des revendications 2 à 4, **caractérisée en ce que** le premier et le deuxième traîneau de transport (18, 19) sont reliés ensemble pour une introduction et une extraction communes dans, respectivement hors du récipient (1).

6. Installation (16) selon l'une quelconque des revendications 1 à 5, **caractérisée en ce qu'**un dispositif d'entraînement, de préférence un vérin pneumatique, est prévu pour le mouvement relatif.

7. Installation (16) selon l'une quelconque des revendications précédentes, **caractérisée par** un dispositif d'entraînement pour un mouvement vertical du dispositif de réception (4) et/ou du logement de support de substrats (7).

8. Installation (16) selon l'une quelconque des revendications précédentes, **caractérisée en ce que** le dispositif de réception (4) comporte des fentes (31).

9. Installation (16) selon la revendication 8, **caractérisée en ce que** les fentes (31) sont configurées de manière complémentaire à la forme des bords des substrats (3).

10. Installation (16) selon l'une des revendications 8 ou 9, **caractérisée en ce que** la largeur des fentes (31) diminue de l'ouverture des fentes au fond des fentes.

11. Installation (16) selon la revendication 10, **caractérisée en ce qu'**une paroi (42) d'une fente (31) est verticale et qu'une autre paroi (43) de la fente (31) est inclinée d'un premier angle prédéfini (α) par rapport à la verticale.

12. Installation (16) selon l'une quelconque des revendications 8 à 11, **caractérisée en ce que** les parois de la fente (38, 39) limitent un deuxième angle prédéfini (β) avec la verticale dans la section d'ouverture de la fente (38).

13. Installation (16) selon la revendication 11 ou 12, **caractérisée en ce que** le premier angle prédéfini (α) est plus petit que le deuxième angle prédéfini (β).

14. Installation (16) selon l'une quelconque des revendications précédentes, **caractérisée en ce que** le dispositif de levage (8) est une barrette en forme de couteau.

15. Installation (16) selon l'une quelconque des revendications précédentes, **caractérisée par** un troisième traîneau de transport (20) pour le dispositif de levage (8).

16. Installation (16) selon la revendication 15 en association avec la revendication 2, **caractérisée en ce que** pour la liaison du premier (18) ou du deuxième (19) traîneau de transport au troisième traîneau de transport (20), il est prévu une liaison articulée.

17. Installation (16) selon la revendication 15 ou 16 en association avec la revendication 2, **caractérisée en ce que** les traîneaux de transport (18, 19, 20) sont disposés coulissants sur une tige de guidage.

18. Installation (16) selon l'une quelconque des revendications précédentes, **caractérisée en ce que** l'installation (16) comporte un capot (21) pouvant être placé au-dessus du récipient (1).

19. Installation (16) selon la revendication 18, **caractérisée en ce que** le capot (21) comporte sur au moins une paroi intérieure des fentes guidage (22) pour les substrats (3).

20. Installation (16) selon la revendication 18 ou 19, **caractérisée en ce qu'**un gaz ou un mélange de gaz peut être acheminé dans le capot (21) pour l'amélioration d'un processus de séchage d'après le procédé Marangoni.

21. Installation (16) selon l'une quelconque des revendications précédentes, **caractérisée en ce que** l'installation (16) est appropriée au traitement chimique des substrats par voie humide.

22. Installation (16) selon l'une quelconque des revendications précédentes, **caractérisée en ce que** l'installation (16) est appropriée au séchage des substrats (3).

23. Installation (16) selon l'une quelconque des revendications précédentes, **caractérisée en ce que** l'installation est appropriée au traitement de galettes de semi-conducteurs.

24. Installation selon l'une quelconque des revendications précédentes, **caractérisée en ce que** le logement de support de substrats (7) comporte au moins deux points d'appuis disposés au milieu dans la direction longitudinale et/ou transversale du support de substrats (5) pour placer un support de substrats.

25. Installation selon la revendication 24, **caractérisée en ce que** les points d'appui sont configurés comme coins de centrage.

26. Installation selon l'une quelconque des revendications précédentes, **caractérisée en ce que** le support de substrats comporte au moins deux barreaux (80, 81, 82, 83) définissant une direction longitudinale, qui sont disposés entre deux plaques latérales (90, 91) disposées transversalement à ces derniers, sachant que le support (5) comporte au moins deux points d'appui (92, 93, 94, 95) disposés au milieu dans la direction longitudinale et/ou transversale pour le dépôt dans le récipient (1).

27. Installation selon la revendication 26, **caractérisée en ce que** sur chacune des plaques latérales (90, 91), des points d'appui (94, 95) sont disposés au milieu.

28. Installation selon la revendication 26 ou 27, **caractérisée en ce que** sur les deux barreaux (81, 82) disposés longitudinalement, des points d'appui (92, 93) sont disposés au milieu.

29. Installation selon la revendication 26 ou 27, **caractérisée en ce que** les points d'appui (92, 93) sont configurés au milieu sur deux pièces d'appui (87, 88) orientées obliquement vers le bas depuis les barreaux (81, 82) disposés longitudinalement.

30. Installation selon l'une quelconque des revendications 26 à 29, **caractérisée en ce que** les points d'appui (92, 93, 94, 95) sont configurés comme des évidements qui peuvent être placés sur des saillies configurées en conséquence dans le récipient.

31. Installation selon la revendication 30, **caractérisée en ce que** les évidements (92, 93, 94, 95) sont configurés comme des rainures de centrage dans lesquelles des coins de centrage configurés dans le récipient (1) peuvent venir en prise.

32. Installation selon l'une quelconque des revendications 26 à 31, **caractérisée en ce que** les plaques latérales (90, 91) sont configurées comme des pièces profilées.

33. Installation selon la revendication 32, **caractérisée en ce que** les plaques latérales (90, 91) configurées comme des pièces profilées sont configurées à double paroi avec des nervures transversales.

34. Installation selon l'une quelconque des revendications précédentes 26 à 33, **caractérisée en ce que** sur les deux - au moins - barreaux (80, 81, 82, 83) disposés longitudinalement, des fentes transversales (86) sont prévues pour le maintien des substrats.

35. Installation selon la revendication 34, **caractérisée en ce que** les fentes transversales (86) sont configurées entre des saillies plates à distance l'un de l'autre, s'étendant radialement depuis les barreaux (80, 81, 82, 83) vers le centre des substrats maintenus (85).

36. Installation selon l'une quelconque des revendications précédentes, **caractérisée par** au moins un adaptateur (100) qui peut être introduit dans le récipient (1) et qui comporte des points d'appui (101 à 104) pour placer dessus le support de substrats (5).

37. Installation selon la revendication 36, **caractérisée par** plusieurs adaptateurs (100) qui peuvent être placés au choix dans le récipient (1) pour la réception de supports de substrats (5) de différentes tailles et/ou de différentes configurations.

38. Installation selon l'une des revendications 36 ou 37, **caractérisée en ce que** l'adaptateur (100) comporte deux points d'appui (101 à 104) disposés au milieu dans la direction longitudinale et/ou transversale pour placer dessus le support de substrats.

39. Installation selon la revendication 38, **caractérisée en ce que** les points d'appui (101 à 104) de l'adaptateur sont configurés comme des coins de centrage.

40. Installation selon l'une quelconque des revendications 36 à 39, **caractérisée en ce que** l'adaptateur (100) comporte deux longerons (105, 106) parallèles à distance l'un de l'autre, qui sont reliés par deux traverses (107, 108) disposées perpendiculairement à eux.

41. Installation selon l'une quelconque des revendications 36 à 40, **caractérisée en ce que** l'adaptateur (100) comporte au moins deux trous de positionnement (110 à 113) dans lesquels viennent en prise des pieds de centrage configurés dans le fond du récipient.

42. Procédé de traitement de substrats par voie humide dans une installation selon l'une quelconque des revendications 1 à 41, dans lequel les substrats (3) sont introduits dans le récipient (1) dans le support de substrats (5) au moyen du logement de support de substrats (7), dans lequel les substrats (3) sont transférés par le support de substrats (5) dans le dispositif de réception (4) pour les substrats (3) disposé dans le récipient (1), et dans lequel les substrats (3) sont levés et sortis du récipient (1) avec le dispositif de levage (8).

43. Procédé selon la revendication 42, **caractérisé en ce que** le support de substrats (5) et le dispositif de réception (4) sont déplacés l'un par rapport à l'autre.

44. Procédé selon la revendication 42 ou 43, **caractérisé en ce que**, pour le transfert des substrats (3) du support de substrats (5) au dispositif de réception (4), le support de substrats (5) est abaissé, respectivement le dispositif de réception (4) est soulevé.

45. Procédé selon l'une quelconque des revendications 42 à 44, **caractérisé en ce que** les substrats (3) et le support de substrats (5) sont séparés pour le séchage.

46. Procédé selon la revendication 45, **caractérisé en ce que** les substrats (3) sont maintenus dans le dispositif de réception (4) pendant l'extraction.
